# EUROPEAN PATENT APPLICATION

(11) **EP 0 562 851 A1**
(43) Date of publication of application: **29.09.1993**
(21) Application number: 93302269.1
(22) Date of filing: 25.03.1993
(51) Int. Cl.: H03H 17/06, H03H 17/02

(54) **Digital signal processing using parallel filters**

(30) Priority: 25.03.1992 GB 9206582
(71) Applicant: QUESTECH LIMITED, Wokingham Berkshire RG11 2PP (GB)
(72) Inventor: Billing, Robert, Crowthorne, Berkshire (GB)
(74) Representative: Bubb, Antony John Allen

(57) **Abstract**

A method of upsampling a data signal comprises sampling the signal at a first repetition rate, to obtain a first set of digitised samples. The samples are then transmitted through a plurality of signal paths arranged in parallel to one another, each path containing a signal filter the characteristics of which are such that it effectively delays the incoming signal by a predetermined fraction of said repetition rate and provides at the filter output an interpolated value of the data signal sample at the point in time corresponding to the appropriate fraction of the repetition rate. The filters collectively provide a series of different fractional delays such that there is provided at the outputs of the filters a second set of digitised samples of the said data signal that correspond to samples that would have been obtained by sampling the original signal at a repetition rate corresponding to the said first repetition rate multiplied by the number of said plurality of signal paths.

## Description

This invention concerns improvements in digital signal processing, and relates more especially to a method and apparatus for deriving and storing samples of a data signal such as a television picture signal. Although the method and apparatus is particularly applicable to the provision of samples of a television picture signal in order to enable video effects to be achieved by transformation of the image data, the invention is not limited to this application, and may be used in any context where it is necessary to derive incremental samples of a digitised analogue data signal with a very small time increment between the required samples.

It is known to affect the transformation of television picture signals to achieve, for example, compression or enlargement of the scale of the picture image, by storing data corresponding to individual pixels of an original image in an appropriate store, and by then addressing the store in a manner determined by the required transformation in order to retrieve data from which transformed values corresponding to pixels to appear in the transformed image can be derived by interpolation. One example of a storage and interpolation system capable of being used in such image transformation is described in EP 0260997.

The image quality of a transformed television image is limited by the resolution of the original stored image, that is to say the number of pixels per unit area, which is in turn determined, in known systems, by the sampling rate at which the original television picture image is converted to digital data. In a conventional digital television system, this may, for example, be 13.5 MHz.

In an attempt to improve the resolution of a transformed video image it has hitherto been proposed, see EP 0460908, to store digitised television signals at a higher than normal sampling rate, e.g. 27 MHz, in order that digital data for interpolation of the transformed image can be provided at a higher resolution. Such an arrangement, however, has the disadvantage that high data rates are necessary to achieve the so-called 'upsampling' and that the degree of upsampling possible is thus limited by the speed of the digital devices.

It is accordingly an object of the present invention to provide a method and apparatus that enables samples of a data signal to be provided at a higher effective repetition rate that is not limited by the speed of the digital devices used to effect sampling and storage of the signal.

In accordance with the invention digitised samples of an analogue data signal are transmitted at a given repetition rate in a plurality of parallel signal paths, each signal path includes a signal filter of a kind that is effective to delay the signal in the corresponding path by a respective fraction of one period of the sampling repetition rate, and the signal transmitted via each signal path is stored in a corresponding memory store, the effective delays achieved in the respective parallel paths being so selected that the digital samples contained in the respective stores collectively comprise a series of samples of the original analogue signal incremented at a rate corresponding to the data sampling rate multiplied by the number of parallel signal paths.

Thus, for example, in the context of a stored television image signal, the multiple data stores coupled to the respective parallel signal paths collectively form an image store from which data can be retrieved for the interpolation of a transformed image at a higher resolution that can be achieved by known sampling processes, and which is, in theory, unlimited by the speed of the digital devices forming the data store and inter-polator.

The invention is illustrated by way of example in the accompanying drawings, in which:
Figure 1 is a block circuit diagram of a so-called finite impulse response filter of known type,
Figure 2 is a diagram representing an original analogue input signal, for example a video image signal, and
Figure 3 is a diagrammatic block circuit diagram of a device in accordance with the invention.

It will be appreciated that whereas the data transmission paths in the drawings are illustrated in single lines, the single lines in fact represent data buses of parallel conductors, the number of conductors in each case corresponding to the number of data bits of the respective signal to be transmitted. Also, the circuit diagrams illustrate diagrammatically the functional elements of a signal processor that are controlled to operate in timed relation to one another by means of a clock pulse oscillator from which is derived timed control pulses for causing data to be read from inputs and written to outputs of the respective elements of the circuit. Since this is conventional and well known to one skilled in the art, the corresponding components of the circuits have been omitted from the drawings for clarity.

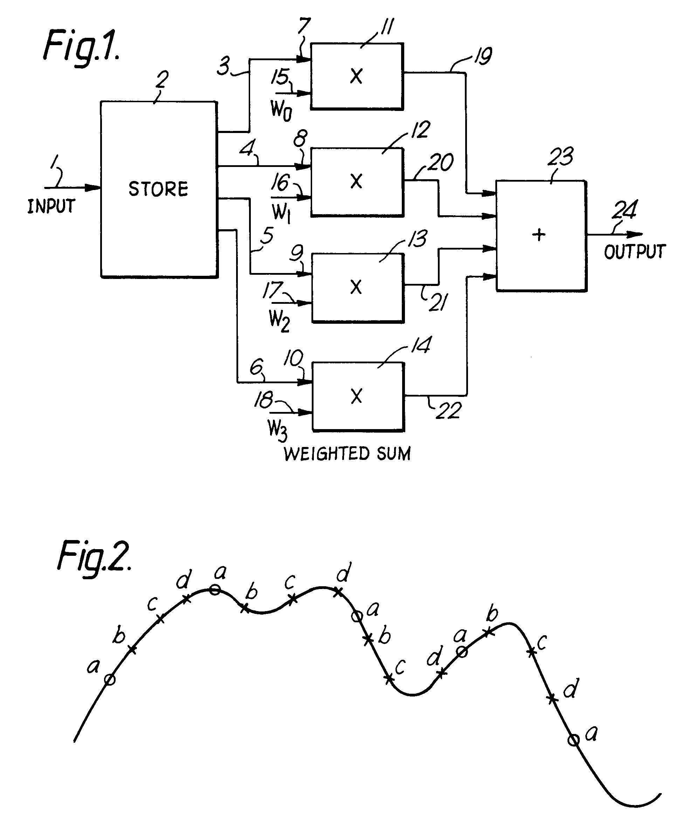

Referring to Fig. 1, reference numeral 1 indicates an input at which a digital signal to be sampled can be applied to a store 2. The store 2 has outputs 3 to 6 from which can be derived samples of the stored signal to be applied to corresponding inputs 7 to 10 of multipliers 11 to 14 The multipliers have, respectively, second inputs 15 to 18 at which may be applied weightings W₀ to W₃. Outputs 19 to 22 of the multipliers are coupled to corresponding inputs of a summing circuit 23 having an output 24.

As will be understood by one skilled in the art, the multipliers 11 to 14 in conjunction with the summing circuit 23 form a so-called finite impulse filter that, in accordance with the selected weightings W₀ to W₃ can derive at the output 24 a signal that corresponds to an original signal represented by consecutive samples contained in the store 2 which has been filtered to remove unwanted high frequency information and in order to produce the effect of fractional displacement of the signal in steps smaller than one period of sampling of the signal. Furthermore, the delayed signal will have an interpolated value that takes account of the change in the value of the original signal between the points at which it was sampled. This will become more apparent from the following description.

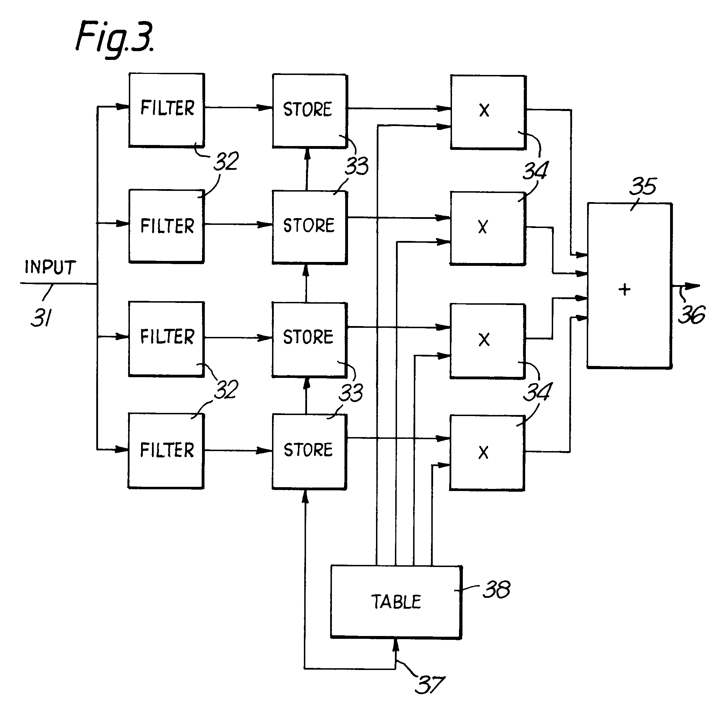

Referring now to Figs. 2 and 3 of the drawings, there will be described a method and apparatus in accordance with the invention, for deriving interpolated samples of an original sampled signal.

Referring to Fig. 2, an original input signal is typically a changing analogue signal as shown. Note that in this figure the high frequency content of the signal has been grossly exaggerated for purposes of illustration, in a real sampled signal the level would change much more slowly. Samples of the signals presented at the input of the apparatus of Fig. 3 are shown as circles in Fig. 2, and represent the signal at equal intervals of time. The points marked by crosses represent extra samples generated by the apparatus at intermediate points in the signal.

Referring to Fig. 3, input samples 31 pass to filters 32. These filters may be as illustrated in Fig. 1 and have two actions, firstly they attenuate the high frequency components of the input signal, and secondly they perform fractional displacement of the input signal in steps of less than one period between adjacent samples. The procedure for the design of such a filter is well-known, and is given in chapter three of 'Digital and Kalman Filtering', by S.M. Bozic.

In the example shown four filters 32 are used, lettered a to d. These are set up to delay the signal by one sample time, three quarters of a sample time, half a sample time, and one quarter of a sample time. For each input sample these filters therefore produce simultaneously four samples, corresponding to four equally spaced time increments in the input signal. These are indicated by the letters a to d, for each input sample, in Fig. 2. As already mentioned, although the original signal samples are obtained only from points a, the finite impulse response filter can derive the actual values of the original signal at points b, c and d in accordance with the delay of the filter. The samples from the filters now pass to the stores 33, from which they are taken as required. A weighted sum of the four samples is produced by the multipliers 34 and adder 35 and becomes the output signal 36.

A control signal, generated by a means which is not part of this invention, is presented at 37. This allows an external control system to specify, at the sampling rate of the signal, the sample position in whole samples (used to address the stores) and fractions. The fractional part is used to address the look-up table 38 which contains the weightings. This arrangement allows the filter to be used in the production of digital video effects, as it allows the interpolated samples to be produced in the order which is required to produce a television picture rotated to any orientation or distorted to any shape.

The part of the invention comprising 34, 35 and 38 is logically equivalent to an FIR filter as already described with reference to Fig. 1, and the same design rules may be applied to it as to the filters 32.

The invention has been illustrated for simplicity as a single dimensional filter, but it could be generalised to an n-dimensional filter to handle data sampled in two or three dimensional space, or sampled in both space and time.

## Claims

1. A method of sampling a data signal, characterised in that it comprises the steps of providing a first set of digitised samples of the said data signal obtained by sampling the signal at a first repetition rate, transmitting the samples through a plurality of signal paths arranged in parallel to one another, each path containing a signal filter the characteristics of which are such that it effectively delays the incoming signal by a predetermined fraction of said repetition rate and provides at the filter output an interpolated value of the data signal sample at the point in time corresponding to the appropriate fraction of the repetition rate, and the filters collectively providing a series of different fractional delays such that there is provided at the outputs of the filters a second set of digitised samples of the said data signal that correspond to samples that would have been obtained by sampling the original signal at a repetition rate corresponding to the said first repetition rate multiplied by the number of said plurality of signal paths.

2. A method as claimed in claim 1, characterised in that the said signal filters are finite impulse response filters.

3. A method as claimed in claim 1 or 2, characterised in that the signal samples provided at the output of each filter are stored in a memory that is addressable separately from the memories storing the outputs of the other filters.

4. A method as claimed in claim 3, characterised in that it comprises the further step of retrieving signal samples collectively from said memories and interpolating the values of the retrieved signal samples to provide a single required signal value.

5. A device for processing a data signal, characterised in that it comprises means (31) for providing a first set of digitised samples of the said data signal obtained by sampling the signal at a first repetition rate, and a plurality of signal filters (32) coupled in parallel to an output of said signal providing means, the characteristics of each of which signal filters (32) are such that it effectively delays the incoming signal by a predetermined fraction of said repetition rate and provides at the filter output an interpolated value of the data signal sample at the point in time corresponding to the appropriate fraction of the repetition rate, and that the arrangement is such that the said filters (32) collectively provide a series of different fractional delays such that there is provided at the outputs of the filters a second set of digitised samples of the said data signal that correspond to samples that would have been obtained by sampling the original signal at a repetition rate corresponding to the said first repetition rate multiplied by the number of said plurality of signal paths.

6. A device as claimed in claim 5, characterised in that the said signal filters (32) are finite impulse response filters.

7. A device as claimed in claim 1 or 2, characterised in that the output of each said filter (32) is coupled to a data store (33) that is addressable separately from the stores (33) coupled to the other filters (32).

8. A device as claimed in claim 7, characterised in that outputs of the said data stores (33) are coupled collectively to an interpolation means (34-38) for deriving an interpolated intermediate value of said data signal from signal values contained in said data stores (33).

9. A device as claimed in claim 8, characterised in that said interpolation means (34-38) comprises a finite impulse response filter.

10. A device as claimed in any one of claims 1-9 characterised in that it is a digital video effects apparatus adapted to process a digital video signal.
